(19) Europäisches Patentamt
European Patent Office
Office européen des brevets

(11) EP 4 468 444 A1

(12) EUROPEAN PATENT APPLICATION
published in accordance with Art. 153(4) EPC

(43) Date of publication:
27.11.2024 Bulletin 2024/48

(51) International Patent Classification (IPC):
H01M 10/42 (2006.01)

(21) Application number: 22957747.3

(22) Date of filing: 08.09.2022

(52) Cooperative Patent Classification (CPC):
H01M 10/42

(86) International application number:
PCT/CN2022/117886

(87) International publication number:
WO 2024/050775 (14.03.2024 Gazette 2024/11)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Contemporary Amperex Technology
Co., Limited
Ningde, Fujian 352100 (CN)

(72) Inventors:
• RONG, Chao
Ningde, Fujian 352100 (CN)

• YE, Wei
Ningde, Fujian 352100 (CN)
• LI, Yongchao
Ningde, Fujian 352100 (CN)
• WU, Shenglu
Ningde, Fujian 352100 (CN)
• XIE, Jihai
Ningde, Fujian 352100 (CN)

(74) Representative: Ziebig Hengelhaupt Intellectual
Property Attorneys
Patentanwaltskanzlei PartGmbB
Leipziger Straße 49
10117 Berlin (DE)

(54) BATTERY SYSTEM CONTROL METHOD AND CONTROL APPARATUS

(57) Embodiments of this application provide a control method and control apparatus for a battery system. The battery system includes N battery branches connected in parallel, N being a positive integer greater than 1. The control method includes: in a case of abnormal communication in at least one of the N battery branches, determining a number M of closed battery branches in the battery system, M being an integer less than or equal to N; and determining a state of charge SOC of the battery system based on the number M of closed battery branches. The control method and control apparatus in the embodiments of this application are conducive to improving the performance of the battery system.

S200

In a case of abnormal communication in at least one of N battery branches, determine a number M of closed battery branches in a battery system, where M is an integer less than or equal to N — S210

Determine a state of charge SOC of the battery system based on the number M of closed battery branches — S220

FIG. 2

## Description

## TECHNICAL FIELD

This application relates to the field of battery technologies, and in particular, to a control method and control apparatus for a battery system.

## BACKGROUND

At present, most battery systems in electric apparatuses adopt a form of parallel connection of a plurality of battery branches to meet the capacity and performance requirements of the electric apparatuses. There is currently no relevant solution available to determine an SOC of the battery system in a case of abnormal communication in a battery branch.

## SUMMARY

In view of this, embodiments of this application provide a control method and control apparatus for a battery system, which are conducive to improving the performance of the battery system.

According to a first aspect, a control method for a battery system is provided, where the battery system includes N battery branches connected in parallel, N being a positive integer greater than 1, and the control method includes: in a case of abnormal communication in at least one of the N battery branches, determining a number M of closed battery branches in the battery system, M being an integer less than or equal to N; and determining a state of charge SOC of the battery system based on the number M of closed battery branches.

In this embodiment, for a battery system consisting of a plurality of battery branches connected in parallel, in a case of abnormal communication in at least one battery branch, the number of closed battery branches in the battery system is determined, and based on the number of closed battery branches, an SOC of the battery system is determined. This is conducive to improving the performance of the battery system.

In one possible implementation, the determining a state of charge SOC of the battery system based on the number M of closed battery branches includes: determining a first SOC value of the battery system based on the number M of closed battery branches, where the first SOC value is an SOC value of the battery system before abnormal communication occurs in the at least one battery branch; and updating the SOC of the battery system based on the first SOC value.

In this embodiment, based on the number of closed battery branches, the first SOC value of the battery system is determined before abnormal communication occurs in the at least one battery branch, and the SOC of the battery system is updated based on the first SOC value. This is conducive to obtaining a more accurate SOC by the user, thus enabling the electric apparatus to exert its best performance.

In one possible implementation, the determining a first SOC value of the battery system based on the number M of closed battery branches includes: determining the first SOC value based on the number M of closed battery branches and communication states of the M closed battery branches in the N battery branches.

In this embodiment, when determining the first SOC value, an MBMU further considers communication states of closed battery branches in the battery system. This is conducive to obtaining a more accurate SOC by the user, thus enabling the electric apparatus to exert its best performance.

In one possible implementation, M is greater than 0, and the determining the first SOC value based on the number M of closed battery branches and communication states of the M closed battery branches in the N battery branches includes: in a case of normal communication of K battery branches in the M battery branches, obtaining SOC values of the K battery branches, where K is a positive integer less than or equal to M; and determining the first SOC value based on the SOC values of the K battery branches and the number M of closed battery branches.

In this embodiment, the first SOC value is determined based on the SOC values of the K closed battery branches with normal communication and the number M of closed battery branches. Battery branches with normal communication have good real-time performance, which is therefore conducive to providing users with a more accurate first SOC value, and in turn provides an accurate basis for subsequent SOC updates, thereby enabling the electric apparatus to exert its optimal performance.

In one possible implementation, the determining the first SOC value based on the SOC values of the K battery branches and the number M of closed battery branches includes: determining a second SOC value based on the SOC values of the K battery branches; and determining the first SOC value based on the second SOC value, the number M of closed battery branches, and a total number N of battery branches included in the battery system.

In this embodiment, the obtained SOC values of the K battery branches are processed and serve as the basis for determining the first SOC value. This is conducive to providing a more accurate first SOC value for the users.

In one possible implementation, the determining the first SOC value based on the second SOC value, the number M of closed battery branches, and a total number N of battery branches included in the battery system includes: determining the first SOC value according to the following formula: B = A * (M/N); where B is the first SOC value and A is the second SOC value.

In this embodiment, the first SOC value is determined based on a proportion of the number of closed battery branches with normal communication to a total number of battery branches in the battery system, which can better avoid the problem of battery cell damage caused by battery over-discharge as compared with directly using the second SOC value as the first SOC value.

In one possible implementation, K is equal to 1, and the determining a second SOC value based on the SOC values of the K battery branches includes: determining a second SOC value based on the SOC values of the K battery branches.

In one possible implementation, K is greater than 1, and the determining a second SOC value based on the SOC values of the K battery branches includes: determining the second SOC value according to the following formula:

$$C = \sum_{i=1}^{i=K} SOC_i * w_i$$

; where C represents the second SOC value, $SOC_i$ represents an SOC value of an i-th battery branch in the K battery branches, and $w_i$ represents a weight corresponding to the i-th battery branch.

In this embodiment, the second SOC value is obtained with a weighted average calculation performed on the obtained SOC values of the K battery branches, so that inconsistency in SOC values of different battery branches can be considered. This is conducive to providing a user with a more accurate first SOC value.

In one possible implementation, the determining the first SOC value based on the number M of closed battery branches and communication states of the M closed battery branches in the N battery branches includes: when M is greater than 0 and abnormal communication occurs in all of the M battery branches, determining an SOC value of the battery system before the abnormal communication occurs in the M battery branches as the first SOC value.

In one possible implementation, the determining a first SOC value of the battery system based on the number M of closed battery branches includes: when M is equal to 0, determining an SOC value of the battery system determined at a previous moment as the first SOC value.

In one possible implementation, the updating the SOC of the battery system based on the first SOC value includes: updating the SOC of the battery system based on the first SOC value and single ampere-hour integration performed on a main circuit current of the battery system.

In one possible implementation, the determining a number M of closed battery branches in the battery system includes: determining the number M of closed battery branches based on a detected insulation resistance value.

In one possible implementation, the determining the number M of closed battery branches based on a detected insulation resistance value includes: determining the number M of closed battery branches based on a resistance value range in which the detected insulation resistance value is located.

In one possible implementation, the determining the number M of closed battery branches based on a resistance value range in which the detected insulation resistance value is located includes: when the detected insulation resistance value belongs to a first resistance value range, determining the number M of closed battery branches as M1; or when the detected insulation resistance value belongs to a second resistance value range, determining the number M of closed battery branches as M2; where M1 is a positive integer less than or equal to M, M2 is a positive integer less than or equal to M, and M1 is greater than M2 if a minimum value of the first resistance value range is greater than a maximum value of the second resistance value range.

In one possible implementation, the determining the number M of closed battery branches based on a resistance value range in which the detected insulation resistance value is located includes: determining the number M of closed battery branches based on the resistance value range in which the detected insulation resistance value is located and a duration for which the detected insulation resistance value remains in the resistance value range.

In this embodiment, the duration for which the detected insulation resistance value remains in the resistance value range is considered. This allows for as accurate as possible determination of the number of closed battery branches in the battery system.

In one possible implementation, the determining the number M of closed battery branches based on the resistance value range in which the detected insulation resistance value is located and a duration for which the detected insulation resistance value remains in the resistance value range includes: when the duration for which the detected insulation resistance value remains in the resistance value range is greater than a time threshold, determining the number M of closed battery branches as a number corresponding to the resistance value range in which the detected insulation resistance value is located.

In one possible implementation, the control method further includes: when any one of the battery branches in the battery system has a fault that causes disconnection of the battery branch, controlling a switch in an insulation detection module in the any one of the battery branches to change the insulation resistance value.

According to a second aspect, a control apparatus for a battery system is provided, where the battery system includes N battery branches connected in parallel, N being a positive integer greater than 1, and the control apparatus includes: a determining unit, configured to determine, in a case of abnormal communication in at least one of the N battery branches, a number M of closed battery branches in the battery system, M being an integer less than or equal to N; where the determining unit is further configured to determine a state of charge SOC of the battery system based on the number M of closed battery branches.

In one possible implementation, the determining unit is specifically configured to: determine a first SOC value of the battery system based on the number M of closed battery branches, where the first SOC value is an SOC value of the battery system before abnormal communication occurs in the at least one battery branch; and update the SOC of the battery system based on the first SOC value.

In one possible implementation, the determining unit is specifically configured to: determine the first SOC value based on the number M of closed battery branches and communication states of the M closed battery branches in the N battery branches.

In one possible implementation, M is greater than 0, and the determining unit is specifically configured to: obtain SOC values of K battery branches in the M battery branches, where communication of the K battery branches is normal, and K is a positive integer less than or equal to M; and determine the first SOC value based on the SOC values of the K battery branches and the number M of closed battery branches.

In one possible implementation, the determining unit is specifically configured to: determine a second SOC value based on the SOC values of the K battery branches; and determine the first SOC value based on the second SOC value, the number M of closed battery branches, and a total number N of battery branches included in the battery system.

In one possible implementation, the determining unit is specifically configured to: determine the first SOC value according to the following formula: B = A * (M/N); where B is the first SOC value and A is the second SOC value.

In one possible implementation, K is equal to 1, and the determining unit is specifically configured to: determine the SOC value of the K battery branch as the second SOC value.

In one possible implementation, K is greater than 1, and the determining unit is specifically configured to: determine the second SOC value according to the following formula: $C = \sum_{i=1}^{i=K} SOC_i * w_i$ ; where C represents the second SOC value, $SOC_i$ represents an SOC value of an i-th battery branch in the K battery branches, and $w_i$ represents a weight corresponding to the i-th battery branch.

In one possible implementation, the determining unit is specifically configured to: when M is greater than 0 and abnormal communication occurs in all of the M battery branches, determine an SOC value of the battery system before the abnormal communication occurs in the M battery branches as the first SOC value.

In one possible implementation, the determining unit is specifically configured to: when M is equal to 0, determine an SOC value of the battery system determined at a previous moment as the first SOC value.

In one possible implementation, the determining unit is specifically configured to: update the SOC of the battery system based on the first SOC value and single ampere-hour integration performed on a main circuit current of the battery system.

In one possible implementation, the determining unit is specifically configured to: determine the number M of closed battery branches based on a detected insulation resistance value.

In one possible implementation, the determining unit is specifically configured to: determine the number M of closed battery branches based on a resistance value range in which the detected insulation resistance value is located.

In one possible implementation, the determining unit is specifically configured to: when the detected insulation resistance value belongs to a first resistance value range, determine the number M of closed battery branches as M1; or when the detected insulation resistance value belongs to a second resistance value range, determine the number M of closed battery branches as M2; where M1 is a positive integer less than or equal to M, M2 is a positive integer less than or equal to M, and M1 is greater than M2 if a minimum value of the first resistance value range is greater than a maximum value of the second resistance value range.

In one possible implementation, the determining unit is specifically configured to: determine the number M of closed battery branches based on the resistance value range in which the detected insulation resistance value is located and a duration for which the detected insulation resistance value remains in the resistance value range.

In one possible implementation, the determining unit is specifically configured to: when the duration for which the detected insulation resistance value remains in the resistance value range is greater than a time threshold, determine the number M of closed battery branches as a number corresponding to the resistance value range in which the detected insulation resistance value is located.

In one possible implementation, the control apparatus further includes: a control unit, configured to control, when any one of the battery branches in the battery system has a fault that causes disconnection of the battery branch, a switch in an insulation detection module in the any one of the battery branches to change the insulation resistance value.

According a third aspect, a battery system is provided, including N battery branches connected in parallel and the control apparatus in the foregoing second aspect and any one of the possible implementations thereof, where N is a positive integer greater than 1.

According to a fourth aspect, a control apparatus for a battery system is provided, where the battery system includes a plurality of battery branches connected in parallel, and the control apparatus includes a memory and a processor, where the memory is configured to store instructions, and the processor is configured to read the instructions and perform the method according to the first aspect and any one of the possible implementations of the first aspect based on the instructions.

According to a fifth aspect, a computer-readable storage medium is provided. The computer-readable storage medium is configured to store a computer program, where the computer program causes a computer to perform the method according to the first aspect and any one of the possible implementations of the first aspect.

According to a sixth aspect, a computer program product is provided, including computer program instructions, where the computer program instructions cause the computer to perform the method according to the first aspect and any one of the possible implementations of the first aspect.

**BRIEF DESCRIPTION OF DRAWINGS**

To describe the technical solutions of the embodiments of this application more clearly, the following briefly describes the accompanying drawings required for describing the embodiments of this application. Apparently, the accompanying drawings described below show merely some embodiments of this application, and persons of ordinary skill in the art may still derive other drawings from the accompanying drawings without creative efforts.

FIG. 1 is a schematic block diagram of a battery system according to an embodiment of this application.

FIG. 2 is a schematic block diagram of a control method for a battery system disclosed in an embodiment of this application.

FIG. 3 is another schematic block diagram of a control method for a battery system disclosed in an embodiment of this application.

FIG. 4 is still another schematic block diagram of a control method for a battery system disclosed in an embodiment of this application.

FIG. 5 is yet another schematic block diagram of a control method for a battery system disclosed in an embodiment of this application.

FIG. 6 is another schematic block diagram of a control method for a battery system disclosed in an embodiment of this application.

FIG. 7 shows a physical model of battery insulation monitoring.

FIG. 8 shows a sampling principle of battery insulation monitoring.

FIG. 9 is a schematic block diagram of a control apparatus for a battery system disclosed in an embodiment of this application.

FIG. 10 is another schematic block diagram of a control apparatus for a battery system disclosed in an embodiment of this application.

**DESCRIPTION OF EMBODIMENTS**

The following further describes the implementations of this application in detail with reference to the accompanying drawings and embodiments. The detailed description of embodiments and the accompanying drawings are intended to illustrate the principle of this application, rather than to limit the scope of this application, meaning this application is not limited to the embodiments described herein.

In the description of this application, it should be noted that, unless otherwise stated, "multiple" means at least two; and the orientations or positional relationships indicated by the terms "upper", "lower", "left", "right", "inside", "outside", and the like are merely for ease and brevity of description of this application rather than indicating or implying that the means or components mentioned must have specific orientations or must be constructed or manipulated according to particular orientations. These terms shall therefore not be construed as limitations on this application. In addition, the terms "first", "second", "third", and the like are merely for the purpose of description and shall not be understood as any indication or implication of relative importance. "Perpendicular" is not perpendicular in the strict sense but within an allowable range of error. "Parallel" is not parallel in the strict sense but within an allowable range of error.

The orientation terms appearing in the following description all are directions shown in the figures, and do not limit the specific structure of the application. In the description of this application, it should also be noted that unless otherwise specified and defined explicitly, the terms "mount", "connect", and "join" should be understood in their general senses. For example, they may refer to a fixed connection, a detachable connection, or an integral connection, and may refer to a direct connection or an indirect connection via an intermediate medium. Persons of ordinary skill in the art can understand specific meanings of these terms in this application as appropriate to specific situations.

In the new energy field, a traction battery may be used as a major traction source for an electric apparatus (such as a vehicle, a ship, or a spacecraft), its importance is taken for granted. To meet the capacity and performance requirements of electric apparatuses, battery systems in electric apparatuses mostly adopt a form of parallel connection of a plurality of battery branches, and each battery branch can communicate with the main controller of the battery system to send data relevant to the battery branch. Typically, once there is abnormal communication in a battery branch of the battery system, operation is forced to stop. For example, for a battery system in an electric apparatus, once there is abnormal communication in a battery branch, it will cause the electric apparatus to fail to start directly.

To improve the robustness of the battery system, the applicant has found that in a case of abnormal communication in a battery branch, as long as there is still a closed battery branch in the battery system, the high voltage of the battery system can be controlled. However, in this situation, it is necessary to implement corresponding control on the battery system to ensure the performance of the battery system, for example, SOC control. Usually, whether a state of charge (state of charge, SOC) value of a traction battery is measured accurately or not has a very important influence on the endurance mileage. During driving, if the SOC estimation is too high, it may cause over-discharge of the battery, leading to premature capacity degradation and shortened service life of the battery; and if the SOC estimation is too low, the battery may stop discharging even though when there is still a relatively high amount of electricity remaining. Both situations result in deviations in battery capacity, which are detrimental to extending the endurance mileage.

In view of this, an embodiment of this application provides a control method and control apparatus for a battery system. For a battery system consisting of a plurality of battery branches connected in parallel, in a case of abnormal communication in at least one battery branch, the number of closed battery branches in the battery system is determined, and based on the number of closed battery branches, an SOC of the battery system is controlled. This is conducive to extending the endurance mileage of the battery system.

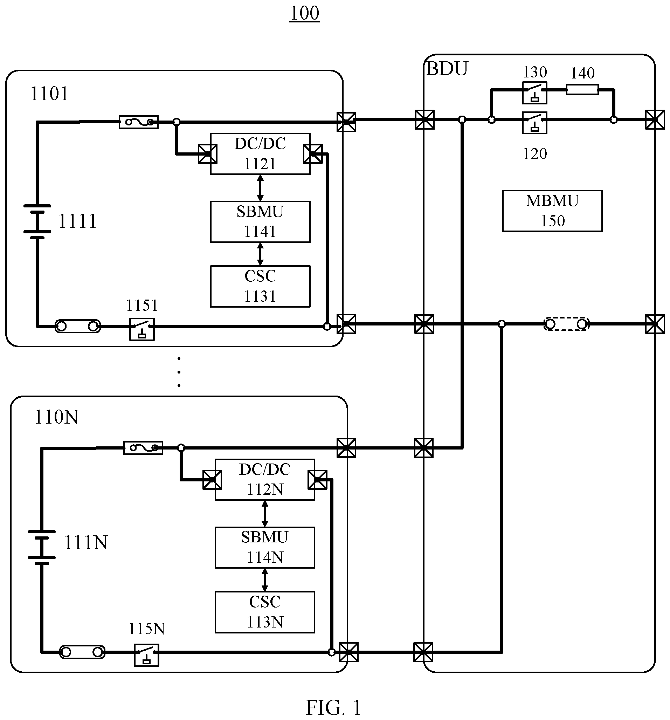

FIG. 1 shows a high-voltage architecture topology diagram of a battery system to which an embodiment of this application is applicable.

As shown in FIG. 1, the battery system 100 may include: a plurality of battery branches connected in parallel, such as battery branch 1101, ..., and battery branch 110N. Optionally, each battery branch may include a battery, and the batteries in the plurality of battery branches are connected in parallel, for example, battery 1111, ..., and battery 111N are connected in parallel, as shown in FIG. 1. Optionally, a relay may further be provided in each battery branch, for example, relay 1151, ..., and relay 115N. Optionally, in a same battery branch, a relay may be connected in series with the negative electrode of the battery to control a high-voltage connection and disconnection between the battery and a vehicle system; that is, the relay is configured to control the closing or opening of the battery branch. Optionally, a direct current/direct current (direct current/direct current, DC/DC) converter may be provided in a battery branch, for example, DC/DC converter 1121, ..., and DC/DC converter 112N. The DC/DC converter is configured to convert a high voltage in the battery branch into a low voltage to provide a low voltage to electric devices and hardware. Optionally, a cell supervisory control (cell supervisory control, CSC) unit may further be provided in a battery branch to collect a cell voltage and cell temperature of the battery, for example, CSC 1131, ...,

and CSC 113N. Optionally, a current sampling unit may further be provided in a battery branch to collect a current of the battery.

Optionally, the battery system 100 may further include a main relay 120, where the main relay 120 is provided on a busbar after a plurality of battery branches are connected in parallel, and is configured to control a high-voltage connection and disconnection between the battery system 100 and the vehicle system.

Optionally, the battery system 100 further includes a pre-charge relay 130 and a pre-charge resistor 140 for high-voltage pre-charge.

Optionally, a master battery management unit (master battery management unit, MBMU) 150 is further provided in the battery system 100. A slave battery management unit (slave battery management unit, SBMU) is provided in a battery branch, for example, SBMU 1141, ..., and SBMU 114N. The MBMU communicates with the SBMU, and the MBMU 150 can periodically obtain status parameters such as current value, cell voltage, relay state, and power of the battery branch from the SBMU 114. The communication mode between the MBMU 150 and the SBMU is not limited to wireless Bluetooth, CAN bus, Ethernet, 5G network communication, and the like.

In some embodiments, an SBMU may be implemented using a battery management system (Battery Management System, BMS) of a corresponding battery branch; and an MBMU 150 may be implemented through a control module of a battery disconnect unit (Battery Disconnect Unit, BDU), or implemented through a BMS of one of the battery branches.

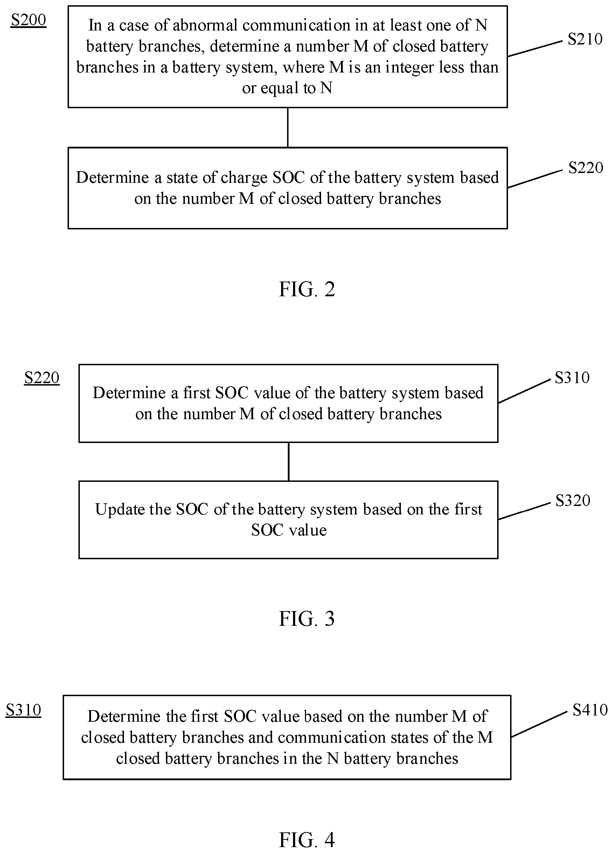

FIG. 2 is a schematic block diagram of a control method 200 for a battery system according to an embodiment of this application. The battery system may include N battery branches connected in parallel, where N is a positive integer greater than 1. The battery system may correspond to the battery system 100 shown in FIG. 1, and the control method 200 may be executed by a control apparatus in the battery system 100, for example, the control method 200 may be executed by the MBMU in the battery system 100. For another example, the control method 200 may be jointly executed by the MBMU and SBMU in the battery system 100. Optionally, as shown in FIG. 2, the control method 200 may include some or all of the following parts:

S210: In a case of abnormal communication in at least one of the N battery branches, determine a number M of closed battery branches in the battery system, M being an integer less than or equal to N.

S220: Determine a state of charge SOC of the battery system based on the number M of closed battery branches.

Normal or abnormal communication of a battery branch refers to the normal or abnormal communication between the SBMU of the battery branch and the MBMU. If communication of a battery branch is normal, the MBMU can receive various status parameters about the battery branch sent by the SBMU, such as current value, cell voltage, relay state, SOC, and allowed charge/discharge power. If abnormal communication occurs in a battery branch, the MBMU cannot obtain various status parameters of the battery branch through the SBMU.

Additionally, the closing or opening of a battery branch refers to the closing or opening of a relay in the battery branch. For example, if a battery branch is closed, the relay in the battery branch is closed; and if a battery branch is disconnected, the relay in the battery branch is disconnected.

When abnormal communication occurs in at least one battery branch in the battery system, that is, the MBMU cannot obtain status parameters of at least one battery branch through the SBMU, then, for the MBMU, the high-voltage state of the at least one battery branch with abnormal communication is unknown. In this case, the MBMU can further determine the number of closed battery branches in the battery system. Then, based on the determined number of closed battery branches, the battery system can determine the SOC of the battery system. Optionally, after determining the SOC of the battery system, the MBMU can control the player in an electric apparatus to output the SOC of the battery system to the user. For example, the MBMU can control a display screen in the electric apparatus to display the SOC of the battery system to the user. For another example, the MBMU can control a speaker in the electric apparatus to announce the SOC of the battery system to the user.

In this embodiment, for a battery system consisting of a plurality of battery branches connected in parallel, in a case of abnormal communication in at least one battery branch, the number of closed battery branches in the battery system is determined, and based on the number of closed battery branches, an SOC of the battery system is determined. This is conducive to maximizing the utilization of the capacity of the battery system; and in addition, this helps to avoid damage to the battery cells caused by over-discharge of the battery, thereby being conducive to enhancing the performance of the battery system.

Optionally, as shown in FIG. 3, step S220 of determining a state of charge SOC of the battery system based on the number M of closed battery branches includes: S310: Determine a first SOC value of the battery system based on the number M of closed battery branches; and S320: Update the SOC of the battery system based on the first SOC value.

Usually, after the SOC of the battery system is determined, the SOC value is output to the user, allowing the user to know a current SOC value of the battery system in real time. This is conducive to the estimation of an endurance mileage of the electric apparatus. In this embodiment of this application, the MBMU can first determine the first SOC value of the battery system based on the number of closed battery branches determined in step S210, and then further update the SOC of the battery system based on the determined first SOC value.

Optionally, in this embodiment of this application, the first SOC value refers to the SOC value of the battery system before abnormal communication occurs in at least one battery branch of the battery system. For example, the first SOC value may be the SOC value of the battery system determined last time before abnormal communication occurs in the at least one battery branch; alternatively, it may be the SOC value of the battery branch determined the last second time before abnormal communication occurs in the at least one battery branch.

In this embodiment, based on the number of closed battery branches, the first SOC value is determined. This is conducive to obtaining a more accurate SOC by the user, thus enabling the electric apparatus to exert its best performance.

Optionally, as shown in FIG. 4, step S310 of determining a first SOC value based on the number M of closed battery branches includes: S410: Determine the first SOC value based on the number M of closed battery branches and communication states of the M closed battery branches in the N battery branches.

During determination of the first SOC value, besides the number of battery branches, communication states of the closed battery branches may further be considered. In one example, if there is a battery branch with normal communication in the closed battery branches, that is, the MBMU can receive various parameters sent by an SBMU of the closed battery branches in real time, for example, the SOC of the battery branch, and for another example, high-voltage state information of the battery branch, indicating that the battery branch is closed. In this case, the first SOC value may be determined based on the SOC sent by the SBMU of the closed battery branch and received by the MBMU. In another example, if there is no battery branch with normal communication in the closed battery branches, that is, high-voltage states of all the closed battery branches in the battery system is unknown, in this case, the MBMU cannot obtain the SOC of the closed battery branches, and the first SOC value may be determined based on the SOC of the battery system determined at a moment before the current moment.

In this embodiment, when determining the first SOC value, the MBMU further considers communication states of closed battery branches in the battery system. This is conducive to obtaining a more accurate SOC by the user, thus enabling the electric apparatus to exert its best performance.

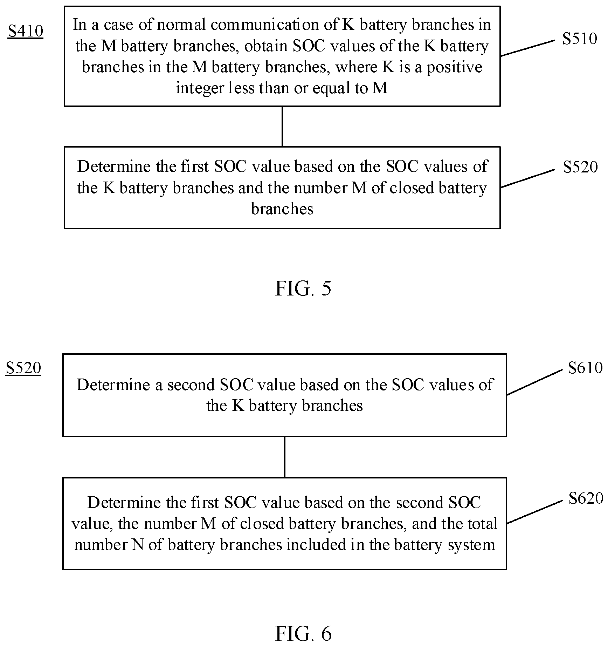

Optionally, as shown in FIG. 5, when M is greater than 0, step S410 of determining the first SOC value based on the number M of closed battery branches and communication states of the M closed battery branches in the N battery branches includes: S510: In a case of normal communication of K battery branches in the M battery branches, obtain SOC values of the K battery branches, where K is a positive integer less than or equal to M; and S520: Determine the first SOC value based on the SOC values of the K battery branches and the number M of closed battery branches.

It was mentioned in the foregoing embodiment that when M is greater than 0, if there is a battery branch with normal communication in the closed battery branches, the MBMU can determine the first SOC value based on the SOC of the closed battery branch with normal communication. First, the MBMU needs to obtain the SOCs of closed battery branches with normal communication. For example, the MBMU can obtain the SOCs of K battery branches, where K is a positive integer less than or equal to M. The K battery branches may represent all the closed battery branches with normal communication in the battery system or the K battery branches may alternatively represent some of the closed battery branches with normal communication in the battery system. After obtaining the SOC values of the K battery branches, the MBMU can further determine the first SOC value based on the number M of closed battery branches.

In this embodiment, the first SOC value is determined based on the SOC values of the K closed battery branches with normal communication and the number M of closed battery branches. Battery branches with normal communication have good real-time performance, which is therefore conducive to providing a user with a more accurate first SOC value, and in turn provides an accurate basis for subsequent SOC updates, thereby enabling the electric apparatus to exert its optimal performance.

Optionally, as shown in FIG. 6, step S520 of determining the first SOC value based on the SOC values of the K battery branches and the number M of closed battery branches includes: S610: Determine a second SOC value based on the SOC values of the K battery branches; and S620: Determine the first SOC value based on the second SOC value, the number M of closed battery branches, and a total number N of battery branches included in the battery system.

After obtaining the SOC values of K closed battery branches with normal communication, the MBMU can process the K SOC values to obtain the second SOC value. For example, the second SOC value may be an average of the K SOC values and for another example, the second SOC value may be a minimum SOC value in the K SOC values. Alternatively, after obtaining the second SOC value, the MBMU may further determine the first SOC value based on the second SOC value, the number M of closed battery branches, and a total number N of battery branches included in the battery system.

In this embodiment, the obtained SOC values of the K battery branches are processed and serve as the basis for determining the first SOC value. This is conducive to providing a more accurate first SOC value for a user.

Optionally, in this embodiment of this application, step S620 of determining the first SOC value based on the second SOC value, the number M of closed battery branches, and a total number N of battery branches included in the battery system includes: determining the first SOC value according to the following formula: B = A * (M/N); where B is the first SOC value and A is the second SOC value.

For example, assume that the battery system includes 3 battery branches. When there is only 1 closed battery branch with normal communication in the battery system, B = A * (1/3); when there are only 2 closed battery branches with normal communication in the battery system, B = A * (2/3); and when there are 3 closed battery branches with normal communication in the battery system, B = A.

In this embodiment, the first SOC value is determined based on a proportion of the number of closed battery branches with normal communication to a total number of battery branches in the battery system, which can better avoid the problem of battery cell damage caused by battery over-discharge as compared with directly using the second SOC value as the first SOC value.

Optionally, in one example, when there is only 1 closed battery branch with normal communication in the battery system, that is, K is equal to 1, step S610 of determining a second SOC value based on the SOC values of the K battery branches includes: determining the SOC value of the one battery branch as the second SOC value.

Optionally, in another example, when there are a plurality of closed battery branches with normal communication in the battery system, that is, K is greater than 1, step 610 of determining a second SOC value based on the SOC values of the K battery branches includes: determining the second SOC value according to the following formula:

$$C = \sum_{i=1}^{i=K} SOC_i * w_i$$

; where C represents the second SOC value, $SOC_i$ represents an SOC value of an i-th battery branch in the K battery branches, and $w_i$ represents a weight corresponding to the i-th battery branch.

It was mentioned in the foregoing embodiment that after obtaining the SOC values of K closed battery branches with normal communication, the MBMU can process the K SOC values to obtain the second SOC value. Specifically, the MBMU can assign a weight to each battery branch, and a weighted average of the K SOC values is the second SOC value. For example, assume that the battery system includes 3 battery branches, and the battery system has only 2 closed battery branches with normal communication, that is, battery branch 1 and battery branch 2, with corresponding SOC values $SOC_1$ and $SOC_2$. If battery branch 1 is assigned a weight of 40% and battery branch 2 is assigned a weight of 60%, then the second SOC value C = $SOC_i$ * 40% + $SOC_2$ * 60%.

In this embodiment, the second SOC value is obtained with a weighted average calculation performed on the obtained SOC values of the K battery branches, so that inconsistency in SOC values of different battery branches can be considered. This is conducive to providing a user with a more accurate first SOC value.

Optionally, in this embodiment of this application, step S410 of determining the first SOC value based on the number M of closed battery branches and communication states of the M closed battery branches in the N battery branches includes: when M is greater than 0 and abnormal communication occurs in all of the M battery branches, determining an SOC value of the battery system before the abnormal communication occurs in the M battery branches as the first SOC value.

It was mentioned in the foregoing embodiment that when M is greater than 0 and there is no battery branch with normal communication in the closed battery branches, that is, the MBMU cannot determine the first SOC value based on an SOC value sent by an SBMU of the closed battery branches, then the MBMU can use the SOC value of the battery system determined last time before abnormal communication occurs in the M battery branches as the first SOC value of the current moment. The MBMU can also use the SOC value of the battery system determined the last second time before abnormal communication occurs in the M battery branches as the first SOC value of the current moment. It should be noted that here the first SOC value determined last time before abnormal communication occurs may refer to the first SOC value determined last time before the abnormal communication occurs in the last battery branch with normal communication in the M battery branches.

Optionally, in other embodiments, when M is equal to 0, that is, all battery branches in the battery system are disconnected. In this case, regardless of whether communication states of the N battery branches in the battery system are abnormal, the SOC of each battery branch remains unchanged. Similarly, the first SOC value remains unchanged. That is, the first SOC value of the battery system at the current moment is the SOC value of the battery system determined in the previous moment until there is a closed battery branch in the battery system.

Optionally, in this embodiment of this application, step S320 of updating the SOC of the battery system based on the first SOC value includes: updating the SOC of the battery system based on the first SOC value and single ampere-hour integration performed on a main circuit current of the battery system.

Usually, there may be various methods to determine the SOC, such as a discharge experiment method, open-circuit voltage method, ampere-hour integration method, Kalman filtering method, neural network method, and the like. Among them, the ampere-hour integration method is widely used in battery management systems due to its advantages such as relatively small limitation by the battery itself, simplicity, reliability, and ability of real-time estimation of the state of charge of the battery. In the ampere-hour integration method, it is necessary to first obtain an initial value of the SOC of the battery, that is, the first SOC value in this embodiment. Further, the total amount of electricity flowing out of the battery is calculated by integrating time and current. The difference between the first SOC value and the calculated total amount of electricity flowing out of the battery is the updated SOC value.

Optionally, in this embodiment of this application, step S210 of determining a number M of closed battery branches in the battery system includes: determining the number M of closed battery branches based on a detected insulation resistance value.

Below is a brief introduction to the principle of battery insulation detection.

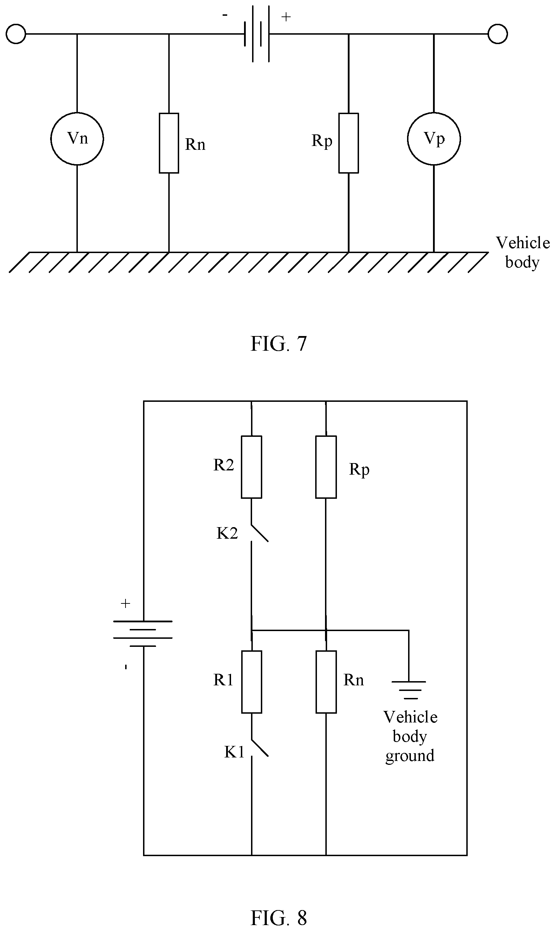

Taking the application of batteries in vehicles as an example, for the driver, the three points most easily accessible are: the high-voltage positive electrode, the high-voltage negative electrode, and the vehicle body (that is, the chassis). Ideally, the vehicle body ground is insulated from the high-voltage battery, which means that the vehicle body ground is insulated from the high-voltage positive electrode, and that the vehicle body ground is insulated from the high-voltage negative electrode. FIG. 7 shows a physical model diagram of battery insulation monitoring. As shown in FIG. 7, the positive electrode of the battery represents the high-voltage positive electrode, the negative electrode of the battery represents the high-voltage negative electrode, Rn represents an equivalent resistance between the high-voltage negative electrode and the vehicle body ground, Rp represents an equivalent resistance between the high-voltage positive electrode and the vehicle body ground, Vn represents an equivalent voltage between the high-voltage negative electrode and the vehicle body ground detected by the BMS, and Vp represents an equivalent voltage between the high-voltage positive electrode and the vehicle body ground detected by the BMS. Ideally, both Rn and Rp are $\infty$. However, factors such as high-voltage breakdown, aging, and harsh environmental conditions can cause a decrease in Rn and Rp. Therefore, insulation monitoring is necessary. For example, the insulation resistance values Rn and Rp may be monitored. As long as either of the resistance values Rn and Rp is greater than a threshold value specified by the international standard, it can ensure the safety of the human body when it accidentally touches any two points among the high-voltage positive electrode, high-voltage negative electrode, and vehicle body ground.

FIG. 8 shows a sampling principle of battery insulation monitoring. As shown in FIG. 8, R1 and R2 respectively represent high-voltage sampling resistors, and their resistance values are known. The resistance values of Rn and Rp are unknown. K1 represents a sampling MOS tube between the high-voltage positive electrode and the vehicle body ground, K2 represents a sampling MOS tube between the high-voltage negative electrode and the vehicle body ground, and U represents a battery voltage U0 detected by the BMS. Here, a circuit composed of R1 and R2 is an insulation sampling module of the battery. The resistance values of Rn and Rp can be calculated according to the following steps: (1) Close K1 and disconnect K2, measure a voltage Vp at two ends of Rp; (2) Disconnect K2 and close K1, measure a voltage Vn at two ends of Rn; (3) Obtain Rn and Rp through the solutions in steps (1) and (2).

Optionally, in this embodiment of this application, it is necessary to provide the insulation sampling module as shown in FIG. 8 in each battery branch of the battery system. In addition, it is also necessary to provide the insulation sampling module as shown in FIG. 8 on the main circuit of the battery system. Through the detection of the insulation resistance value on the main circuit of the battery system by the MBMU, the number M of closed battery branches in the battery system can be determined. Optionally, the detected insulation resistance values in this embodiment may be the insulation resistance values Rn or Rp as shown in FIG. 7 or FIG. 8.

Optionally, in this embodiment of this application, the control method 200 further includes: when any one of the battery branches in the battery system has a fault that causes disconnection of the battery branch, controlling a switch in an insulation detection module in the any one of the battery branches to change the insulation resistance value.

Usually, whether to disconnect a battery branch is determined based on the fault that occurs in the battery branch. For example, the faults of a battery branch may be divided into five fault levels. A level 1 fault represents a lightest fault, while a level 5 fault level represents a most severe fault. Different fault levels may correspond to different fault operations. For example, a level 3 fault level may be configured as indicating the need for power reduction control of the battery branch, in which case, to avoid the impact of this battery branch on other closed battery branches, this battery branch may be directly disconnected. A level 5 fault level indicates a collision fault, which requires the battery branch to be disconnected immediately. A level 4 fault level is between a level 3 fault level and a level 5 fault level. For example, it may indicate that a fault occurs and requires the battery branch to be disconnected, not immediately, but after a time of delay. The MBMU can be configured as controlling a battery branch to be disconnected once a fault above level 3 (including level 3) occurs in the battery branch.

The MBMU can be configured as disconnecting a battery branch once a fault of level 3 or higher (including level 3) occurs in the battery branch. At this time, an SBMU of the battery branch can control a positive electrode-to-ground sampling MOS tube and a negative electrode-to-ground sampling MOS tube in the insulation detection module in the battery branch, so that an insulation resistance value of the battery branch is connected in parallel with an insulation resistance value of the main circuit, thereby changing the insulation resistance value detected by the MBMU. The MBMU can then determine the number M of closed battery branches in the battery system based on the detected insulation resistance value.

Optionally, in this embodiment of this application, step S910 of determining the number M of closed battery branches based on a detected insulation resistance value includes: determining the number M of closed battery branches based on a resistance value range in which the detected insulation resistance value is located.

It was mentioned in the foregoing embodiment that when a certain battery branch is disconnected, a switch in the insulation detection module in the battery branch is closed, and the insulation resistance value of the battery branch is connected in parallel with the resistance value of the main circuit. According to the principle of parallel connection of circuits, the insulation resistance value detected by the MBMU, namely the insulation resistance value on the main circuit, will decrease. For example, the battery system includes 3 battery branches and if there is no disconnected battery branch in the battery system, the insulation resistance value detected by the MBMU is 700 S2/V; if there is 1 disconnected battery branch in the battery system, the insulation resistance value detected by the MBMU is 500 Q/V; and if there are 2 disconnected battery branches in the battery system, the insulation resistance value detected by the MBMU is 300 Q/V.

After multiple tests, the applicant has found that for a same type of battery system, the insulation resistance values can be divided into a plurality of resistance value ranges, and different numbers of closed battery branches in the battery system correspond to different resistance value ranges where the insulation resistance values fall. For example, for a battery system including 3 battery branches, a resistance value range [650 Q/V, 750 Ω/V] corresponds to 3 closed battery branches, a resistance value range [450 Q/V, 550 Q/V] corresponds to 2 closed battery branches, and a resistance value range [250 Q/V, 350 Ω/V] corresponds to 1 closed battery branch. That is to say, in practical applications, the number M of closed battery branches in the battery system can be determined based on a resistance value range in which an insulation resistance value detected by the MBMU is located and a mapping relationship between the resistance value ranges and the numbers of closed battery branches stored internally.

Optionally, in this embodiment of this application, the determining the number M of closed battery branches based on a resistance value range in which the detected insulation resistance value is located includes: when the detected insulation resistance value belongs to a first resistance value range, determining the number M of closed battery branches as M1; or when the detected insulation resistance value belongs to a second resistance value range, determining the number M of closed battery branches as M2; where M1 is a positive integer less than or equal to M, M2 is a positive integer less than or equal to M, and M1 is greater than M2 if a minimum value of the first resistance value range is greater than a maximum value of the second resistance value range.

As mentioned above, a smaller insulation resistance value detected by the MBMU indicates a greater number of disconnected battery branches, that is, a less number of closed battery branches; while a larger insulation resistance value detected by the MBMU indicates a greater number of closed battery branches. It should be noted that here the first resistance value range being greater than the second resistance value range means that a minimum value of the first resistance value range is greater than a maximum value of the second resistance value range, and the first and second resistance value ranges do not overlap.

Optionally, in this embodiment of this application, the determining the number M of closed battery branches based on a resistance value range in which the detected insulation resistance value is located includes: determine the number M of closed battery branches based on the resistance value range in which the detected insulation resistance value is located and a duration for which the detected insulation resistance value remains in the resistance value range.

If an insulation resistance value detected by the MBMU remains in a certain resistance value range for a short period of time, the change in this insulation resistance value may be due to measurement errors rather than the closing of a switch in an insulation detection module in the battery branch. In other words, even if an insulation resistance value detected by the MBMU is within the foregoing first resistance value range, it cannot be accurately determined that the number of closed battery branches in the battery system is M1. Measurement errors can be eliminated only when the insulation resistance value detected by the MBMU remains in the foregoing first resistance value range for a duration exceeding a certain period of time.

In this embodiment, the duration for which the detected insulation resistance value remains in the resistance value range is considered. This allows for as accurate as possible determination of the number of closed battery branches in the battery system.

Optionally, in this embodiment of this application, the determining the number M of closed battery branches based on the resistance value range in which the detected insulation resistance value is located and a duration for which the detected insulation resistance value remains in the resistance value range includes: when the duration for which the detected insulation resistance value remains in the resistance value range is greater than a time threshold, determining the number M of closed battery branches as a number corresponding to the resistance value range in which the detected insulation resistance value is located.

Similarly, when the duration for which the detected insulation resistance value remains in the resistance value range is less than or equal to the time threshold, the determined number M of battery branches remains the same as the number of battery branches determined the last time.

It should be noted that the time threshold may also be an empirical value obtained through multiple tests. This is not limited in the embodiments of this application.

Optionally, in other embodiments, the MBMU may also determine the number of closed battery branches in the battery system based on other detected parameters. For example, the MBMU may use a current sampling unit to detect a current on the main circuit of the battery system to determine the number M of closed battery branches in the battery system. For example, a current sampling unit may be provided on the main circuit, and based on a current range in which a current value collected by the current sampling unit is located, the number M of closed battery branches in the battery system can be determined.

Optionally, in this embodiment of this application, before the MBMU determines the number M of closed battery branches in the battery system, the MBMU can first determine the communication states of the plurality of battery branches. For example, the MBMU can assign a counter to each battery branch. Each time the MBMU receives a message from an SBMU of a battery branch, it increments the corresponding counter by 1. If a counter does not change within a certain period of time, the MBMU considers that abnormal communication occurs in the battery branch corresponding to the counter.

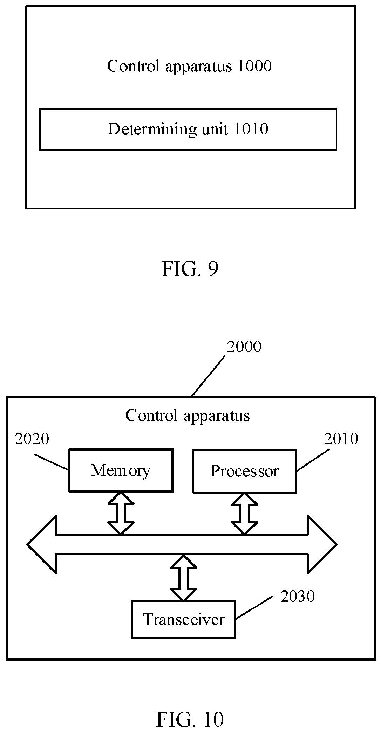

The control method for a battery system in this embodiment of this application is described in detail above. The following describes in detail the control apparatus in this embodiment of this application with reference to FIG. 9. The technical features described in the method embodiments are applicable to the following apparatus embodiments.

FIG. 9 is a schematic block diagram of a control apparatus 1000 for a battery system according to an embodiment of this application. The battery system includes N battery branches connected in parallel, where N is a positive integer greater than 1. As shown in FIG. 9, the control apparatus 1000 includes some or all of the following parts:

a determining unit 1010, configured to determine, in a case of abnormal communication in at least one of the N battery branches, a number M of closed battery branches in the battery system, M being an integer less than or equal to N.

The determining unit 1010 is further configured to determine a state of charge SOC of the battery system based on the number M of closed battery branches.

Optionally, in this embodiment of this application, the determining unit 1010 is further configured to: determine a first SOC value based on the number M of closed battery branches, where the first SOC value is an SOC value of the battery system before abnormal communication occurs in the at least one battery branch; and update the SOC of the battery system based on the first SOC value.

Optionally, in this embodiment of this application, the determining unit 1010 is specifically configured to: determine the first SOC value based on the number M of closed battery branches and communication states of the M closed battery branches in the N battery branches.

Optionally, in this embodiment of this application, M is greater than 0, and the determining unit 1010 is specifically configured to: in a case of normal communication of K battery branches in the M battery branches, obtain SOC values of the K battery branches, where K is a positive integer less than or equal to M; and determine the first SOC value based on the SOC values of the K battery branches and the number M of closed battery branches.

Optionally, in this embodiment of this application, the determining unit 1010 is specifically configured to: determine a second SOC value based on the SOC values of the K battery branches; and determine the first SOC value based on the second SOC value, the number M of closed battery branches, and a total number N of battery branches included in the battery system.

Optionally, in this embodiment of this application, the determining unit 1010 is specifically configured to: determine the first SOC value according to the following formula: B = A * (M/N); where B is the first SOC value and A is the second SOC value.

Optionally, in this embodiment of this application, K is equal to 1, and the determining unit 1020 is specifically configured to: determine the SOC value of the one battery branch as the second SOC value.

Optionally, in this embodiment of this application, K is greater than 1, and the determining unit 1010 is specifically configured to: determine the second SOC value according to the following formula:

$$C = \sum_{i=1}^{i=K} SOC_i * w_i$$

; where C represents the second SOC value, $SOC_i$ represents an SOC value of an i-th battery branch in the K battery branches, and $w_i$ represents a weight corresponding to the i-th battery branch.

Optionally, in this embodiment of this application, the determining unit 1010 is specifically configured to: when M is greater than 0 and abnormal communication occurs in all of the M battery branches, determine an SOC value of the battery system before the abnormal communication occurs in the M battery branches as the first SOC value.

Optionally, in this embodiment of this application, the determining unit 1010 is specifically configured to: update the SOC of the battery system based on the first SOC value and single ampere-hour integration performed on a main circuit current of the battery system.

Optionally, in this embodiment of this application, the determining unit 1010 is specifically configured to: determine the number M of closed battery branches based on a detected insulation resistance value.

Optionally, in this embodiment of this application, the determining unit 1010 is specifically configured to: determine the number M of closed battery branches based on a resistance value range in which the detected insulation resistance value is located.

Optionally, in this embodiment of this application, the determining unit 1010 is specifically configured to: when the detected insulation resistance value belongs to a first resistance value range, determine the number M of closed battery branches as M1; or when the detected insulation resistance value belongs to a second resistance value range, determine the number M of closed battery branches as M2; where M1 is a positive integer less than or equal to M, M2 is a positive integer less than or equal to M, and M1 is greater than M2 if a minimum value of the first resistance value range is greater than a maximum value of the second resistance value range.

Optionally, in this embodiment of this application, the determining unit 1010 is specifically configured to: determine the number M of closed battery branches based on the resistance value range in which the detected insulation resistance value is located and a duration for which the detected insulation resistance value remains in the resistance value range.

Optionally, in this embodiment of this application, the determining unit 1010 is specifically configured to: when the duration for which the detected insulation resistance value remains in the resistance value range is greater than a time threshold, determine the number M of closed battery branches as a number corresponding to the resistance value range in which the detected insulation resistance value is located.

Optionally, in this embodiment of this application, the control apparatus 1000 is further configured to: a control unit, configured to control, when any one of the battery branches in the battery system has a fault that causes disconnection of the battery branch, a switch in an insulation detection module in the any one of the battery branches to change the insulation resistance value.

It should be understood that the above and other operations and/or functions of each module in the control apparatus 1000 are used to realize the corresponding flows in the foregoing method embodiments. For brevity, details are not repeated herein.

Optionally, this embodiment of this application further provides a battery system, including N battery branches connected in parallel and the control apparatus 1000 shown in FIG. 9, where N is a positive integer greater than 1.

FIG. 10 is a schematic block diagram of a control apparatus 2000 according to an embodiment of this application. As shown in FIG. 10, the control apparatus 2000 includes a processor 2010 and a memory 2020, where the memory 2020 is configured to store instructions, and the processor 2010 is configured to read the instructions and perform the methods of the foregoing various embodiments of this application according to the instructions.

The memory 2020 may be a separate device independent of the processor 2010 or it may be integrated in the processor 2010.

Optionally, as shown in FIG. 10, the control apparatus 2000 may further include a transceiver 2030, and the processor 2010 may control the transceiver 2030 to communicate with other devices. Specifically, information or data can be sent to or received from other devices.

It should be understood that the processor in this embodiment of this application may be an integrated circuit chip with a signal processing capability. In an implementation process, steps in the foregoing method embodiments can be implemented by using a hardware integrated logic circuit in the processor, or by using instructions in a form of software. The foregoing processor may be a general-purpose processor, a digital signal processor (Digital Signal Processor, DSP), an application-specific integrated circuit (Application Specific Integrated Circuit, ASIC), a field programmable gate array (Field Programmable Gate Array, FPGA) or another programmable logic device, a discrete gate or transistor logic device, or a discrete hardware component. The methods, steps, and logical block diagrams disclosed in the embodiments of this application can be implemented or performed. The general-purpose processor may be a microprocessor, or the processor may also be any conventional processor or the like. The steps of the methods disclosed with reference to the embodiments of this application may be directly implemented by a hardware decoding processor, or may be implemented by a combination of hardware and software modules in a decoding processor. The software module may be located in a storage medium mature in the art, such as a random access memory, a flash memory, a read-only memory, a programmable read-only memory or electrically erasable programmable memory, or a register. The storage medium is located in the memory, and the processor reads information in the memory and completes the steps in the foregoing methods in combination with hardware of the processor.

It can be understood that the memory in this embodiment of this application may be a volatile memory or a non-volatile memory, or may include both a volatile memory and a non-volatile memory. The non-volatile memory may be a read-only memory (Read-Only Memory, ROM), a programmable read-only memory (Programmable ROM, PROM), an erasable programmable read-only memory (Erasable PROM, EPROM), an electrically erasable programmable read-only memory (Electrically EPROM, EEPROM), or a flash memory. The volatile memory may be a random access memory (Random Access Memory, RAM) and is used as an external cache. Through illustrative but not limitative description, many forms of RAMs may be used, for example, a static random access memory (Static RAM, SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDR SDRAM), an enhanced synchronous dynamic random access memory (Enhanced SDRAM, ESDRAM), a synchlink dynamic random access memory (Synchlink DRAM, SLDRAM), and a direct rambus random access memory (Direct Rambus RAM, DR RAM). It should be noted that the memory of the systems and methods described in this specification includes but is not limited to these and any other proper types of memories.

An embodiment of this application further provides a readable storage medium, configured to store a computer program.

Optionally, the computer-readable storage medium can be applied to the control apparatus in the embodiments of this application, and the computer program causes a computer to execute the corresponding flows implemented by the control apparatus in various methods of the embodiments of this application. For brevity, details are not repeated herein.

An embodiment of this application further provides a computer program product, including computer program instructions.

Optionally, the computer program product can be applied to the control apparatus in the embodiments of this application, and the computer program instructions cause a computer to execute the corresponding flows implemented by the control apparatus in various methods of the embodiments of this application. For brevity, details are not repeated herein.

An embodiment of this application further provides a computer program.

Optionally, the computer program can be applied to the control apparatus in the embodiments of this application, and when the computer program is executed on a computer, it causes the computer to execute the corresponding flows implemented by the control apparatus in various methods of the embodiments of this application. For brevity, details are not repeated herein.

Although this application has been described with reference to some preferred embodiments, various modifications to this application and replacements of the components therein with equivalents can be made without departing from the scope of this application. In particular, as long as there is no structural conflict, the various technical features mentioned in the embodiments can be combined in any manner. This application is not limited to the specific embodiments disclosed in this specification but includes all technical solutions falling within the scope of the claims.

**Claims**

1. A control method for a battery system, **characterized in that** the battery system comprises N battery branches connected in parallel, N being a positive integer greater than 1, and the control method comprises:

in a case of abnormal communication in at least one of the N battery branches, determining a number M of closed battery branches in the battery system, M being an integer less than or equal to N; and
determining a state of charge SOC of the battery system based on the number M of closed battery branches.

2. The control method according to claim 1, **characterized in that** the determining a state of charge SOC of the battery system based on the number M of closed battery branches comprises:

determining a first SOC value of the battery system based on the number M of closed battery branches, wherein the first SOC value is an SOC value of the battery system before abnormal communication occurs in the at least one battery branch; and
updating the SOC of the battery system based on the first SOC value.

3. The control method according to claim 2, **characterized in that** the determining a first SOC value of the battery system based on the number M of closed battery branches comprises:
determining the first SOC value based on the number M of closed battery branches and communication states of the M closed battery branches in the N battery branches.

4. The control method according to claim 3, **characterized in that** M is greater than 0, and the determining the first SOC value based on the number M of closed battery branches and communication states of the M closed battery branches in the N battery branches comprises:

obtaining SOC values of K battery branches in the M battery branches, wherein communication of the K battery branches is normal, and K is a positive integer less than or equal to M; and
determining the first SOC value based on the SOC values of the K battery branches and the number M of closed battery branches.

5. The control method according to claim 4, **characterized in that** the determining the first SOC value based on the SOC values of the K battery branches and the number M of closed battery branches comprises:

determining a second SOC value based on the SOC values of the K battery branches; and
determining the first SOC value based on the second SOC value, the number M of closed battery branches, and a total number N of battery branches comprised in the battery system.

6. The control method according to claim 5, **characterized in that** the determining the first SOC value based on the second SOC value, the number M of closed battery branches, and a total number N of battery branches comprised in the battery system comprises:

determining the first SOC value according to the following formula:

$$B = A * (M/N);$$

wherein B is the first SOC value and A is the second SOC value.

7. The control method according to claim 5 or 6, **characterized in that** K is equal to 1, and the determining a second SOC value based on the SOC values of the K battery branches comprises:
determining the SOC value of the K battery branch as the second SOC value.

8. The control method according to claim 5 or 6, **characterized in that** K is greater than 1, and the determining a second SOC value based on the SOC values of the K battery branches comprises:

determining the second SOC value according to the following formula:

$$C = \sum_{i=1}^{i=K} SOC_i * w_i;$$

wherein C represents the second SOC value, $SOC_i$ represents an SOC value of an i-th battery branch in the K battery branches, and $w_i$ represents a weight corresponding to the i-th battery branch.

9. The control method according to claim 3, **characterized in that** the determining the first SOC value based on the number M of closed battery branches and communication states of the M closed battery branches in the N battery branches comprises:
when M is greater than 0 and abnormal communication occurs in all of the M battery branches, determining an SOC value of the battery system before the abnormal communication occurs in the M battery branches as the first SOC value.

10. The control method according to claim 2, **characterized in that** the determining a first SOC value of the battery system based on the number M of closed battery branches comprises:
when M is equal to 0, determining an SOC value of the battery system determined at a previous moment as the first SOC value.

11. The control method according to any one of claims 2 to 10, **characterized in that** the updating the SOC of the battery system based on the first SOC value comprises:
updating the SOC of the battery system based on the first SOC value and single ampere-hour integration performed on a main circuit current of the battery system.

12. The control method according to any one of claims 1 to 11, **characterized in that** the determining a number M of closed battery branches in the battery system comprises:
determining the number M of closed battery branches based on a detected insulation resistance value.

13. The control method according to claim 12, **characterized in that** the determining the number M of closed battery branches based on a detected insulation resistance value comprises:
determining the number M of closed battery branches based on a resistance value range in which the detected insulation resistance value is located.

14. The control method according to claim 13, **characterized in that** the determining the number M of closed battery branches based on a resistance value range in which the detected insulation resistance value is located comprises:

when the detected insulation resistance value belongs to a first resistance value range, determining the number M of closed battery branches as M1; or
when the detected insulation resistance value belongs to a second resistance value range, determining the number M of closed battery branches as M2;
wherein M1 is a positive integer less than or equal to M, M2 is a positive integer less than or equal to M, and M1 is greater than M2 if a minimum value of the first resistance value range is greater than a maximum value of the second resistance value range.

15. The control method according to claim 13 or 14, **characterized in that** the determining the number M of closed battery branches based on a resistance value range in which the detected insulation resistance value is located comprises:
determining the number M of closed battery branches based on the resistance value range in which the detected insulation resistance value is located and a duration for which the detected insulation resistance value remains in the resistance value range.

16. The control method according to claim 15, **characterized in that** the determining the number M of closed battery branches based on the resistance value range in which the detected insulation resistance value is located and a duration for which the detected insulation resistance value remains in the resistance value range comprises:
when the duration for which the detected insulation resistance value remains in the resistance value range is greater than a time threshold, determining the number M of closed battery branches as a number corresponding to the resistance value range in which the detected insulation resistance value is located.

17. The control method according to any one of claims 12 to 16, **characterized in that** the control method further comprises:
when any one of the battery branches in the battery system has a fault that causes disconnection of the battery branch, controlling a switch in an insulation detection module in the any one of the battery branches to change the insulation resistance value.

18. A control apparatus for a battery system, **characterized in that** the battery system comprises N battery branches connected in parallel, N being a positive integer greater than 1, and the control apparatus comprises:

a determining unit configured to determine, in a case of abnormal communication in at least one of the N battery branches, a number M of closed battery branches in the battery system, M being an integer less than or equal to N;
wherein the determining unit is further configured to determine a state of charge SOC of the battery system based on the number M of closed battery branches.

19. A battery system, **characterized in that** the battery system comprises N battery branches connected in parallel and the control apparatus according to claim 18, N being a positive integer greater than 1.

20. A control apparatus for a battery system, **characterized in that** the battery system comprises N battery branches connected in parallel, N being a positive integer greater than 1, and that the control apparatus comprises a memory and a processor, wherein the memory is configured to store instructions, and the processor is configured to read the instructions and perform the method according to any one of the claims 1 to 17 according to the instructions.

21. A computer-readable storage medium, **characterized by** being configured for storing a computer program, wherein the computer program causes a computer to perform the method according to any one of claims 1 to 17.

22. A computer program product, **characterized by** comprising computer program instructions, wherein the computer program instructions cause a computer to perform the method according to any one of claims 1 to 17.

100

FIG. 1

S200

In a case of abnormal communication in at least one of N battery branches, determine a number M of closed battery branches in a battery system, where M is an integer less than or equal to N — S210

Determine a state of charge SOC of the battery system based on the number M of closed battery branches — S220

FIG. 2

S220

Determine a first SOC value of the battery system based on the number M of closed battery branches — S310

Update the SOC of the battery system based on the first SOC value — S320

FIG. 3

S310

Determine the first SOC value based on the number M of closed battery branches and communication states of the M closed battery branches in the N battery branches — S410

FIG. 4

S410

In a case of normal communication of K battery branches in the M battery branches, obtain SOC values of the K battery branches in the M battery branches, where K is a positive integer less than or equal to M — S510

Determine the first SOC value based on the SOC values of the K battery branches and the number M of closed battery branches — S520

FIG. 5

S520

Determine a second SOC value based on the SOC values of the K battery branches — S610

Determine the first SOC value based on the second SOC value, the number M of closed battery branches, and the total number N of battery branches included in the battery system — S620

FIG. 6

FIG. 7

FIG. 8

Control apparatus 1000

Determining unit 1010

FIG. 9

2000

Control apparatus

2020

Memory

Processor

2010

Transceiver

2030

FIG. 10

## INTERNATIONAL SEARCH REPORT

International application No.

**PCT/CN2022/117886**

### A. CLASSIFICATION OF SUBJECT MATTER

H01M10/42(2006.01)i

According to International Patent Classification (IPC) or to both national classification and IPC

### B. FIELDS SEARCHED

Minimum documentation searched (classification system followed by classification symbols)

IPC:H01M

Documentation searched other than minimum documentation to the extent that such documents are included in the fields searched

Electronic data base consulted during the international search (name of data base and, where practicable, search terms used)

VEN, CNABS, CNTXT, USTXT, EPTXT, WOTXT, CNKI: 电池, 控制, 并联, 支, 路, 通讯, 通信, 网络, 异常, 故障, 中断, 断开, 断连, 失效, 问题, 不能, 荷电, SOC, 数量, 更新, 估, 确定, 算, 车, 续航, 里程, 行驶, 运行, battery, control+, parallel, branch?, route?, communication, network, abnormal, fault, failure, interrupt, disconnect+, problem, charge, number, updat+, estimat+, determine, calculat+, prediction, vehicle, endurance, range, mileage

### C. DOCUMENTS CONSIDERED TO BE RELEVANT

| Category* | Citation of document, with indication, where appropriate, of the relevant passages | Relevant to claim No. |
|---|---|---|
| Y | CN 104842814 A (XI'AN SILVER BUS CORP.) 19 August 2015 (2015-08-19) description, paragraphs 19-64, and figure 1 | 1, 12-13, 15-22 |
| Y | US 2007247106 A1 (HITACHI LTD.) 25 October 2007 (2007-10-25) description, paragraphs 22-59, and figures 1-8 | 1, 12-13, 15-22 |
| A | CN 107565183 A (SHANDONG UNIVERSITY) 09 January 2018 (2018-01-09) entire document | 1-22 |
| A | CN 102341285 A (TOYOTA MOTOR CORP.) 01 February 2012 (2012-02-01) entire document | 1-22 |
| A | US 2012112685 A1 (MYERS MOTORS, LLC et al.) 10 May 2012 (2012-05-10) entire document | 1-22 |
| A | CN 106394313 A (BEIJING ELECTRIC VEHICLE CO., LTD.) 15 February 2017 (2017-02-15) entire document | 1-22 |

☑ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 April 2023** | **21 April 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2022/117886**

**C.     DOCUMENTS CONSIDERED TO BE RELEVANT**

| Category* | Citation of document, with indication, where appropriate, of the relevant passages | Relevant to claim No. |
|---|---|---|
| A | CN 112462917 A (GUANGZHOU ZHIGUANG ELECTRIC TECHNOLOGY CO., LTD. et al.) 09 March 2021 (2021-03-09)<br>entire document | 1-22 |
| A | CN 112865264 A (POWERAMP TECHNOLOGY LIMITED) 28 May 2021 (2021-05-28)<br>entire document | 1-22 |
| A | JP 2017158264 A (PANASONIC IP MANAGEMENT CO., LTD.) 07 September 2017 (2017-09-07)<br>entire document | 1-22 |
| A | US 2017182893 A1 (TOYOTA JIDOSHA K.K.) 29 June 2017 (2017-06-29)<br>entire document | 1-22 |

EP 4 468 444 A1

| INTERNATIONAL SEARCH REPORT | | | | | International application No. |
| Information on patent family members | | | | | PCT/CN2022/117886 |

| Patent document cited in search report | | | Publication date (day/month/year) | Patent family member(s) | | | Publication date (day/month/year) |
|---|---|---|---|---|---|---|---|
| CN | 104842814 | A | 19 August 2015 | CN | 104842814 | B | 23 June 2017 |
| US | 2007247106 | A1 | 25 October 2007 | JP | 2007282375 | A | 25 October 2007 |
| | | | | JP | 4745879 | B2 | 10 August 2011 |
| | | | | US | 7830126 | B2 | 09 November 2010 |
| CN | 107565183 | A | 09 January 2018 | CN | 107565183 | B | 22 May 2020 |
| CN | 102341285 | A | 01 February 2012 | WO | 2010100736 | A1 | 10 September 2010 |
| | | | | JP | 4868088 | B2 | 01 February 2012 |
| | | | | JPWO | 2010100736 | A1 | 06 September 2012 |
| | | | | US | 2012016547 | A1 | 19 January 2012 |
| | | | | US | 8229616 | B2 | 24 July 2012 |
| | | | | EP | 2404801 | A1 | 11 January 2012 |
| | | | | EP | 2404801 | A4 | 31 October 2012 |
| | | | | EP | 2404801 | B1 | 26 July 2017 |
| | | | | CN | 102341285 | B | 30 July 2014 |
| US | 2012112685 | A1 | 10 May 2012 | WO | 2010118039 | A1 | 14 October 2010 |
| | | | | CA | 2757967 | A1 | 14 October 2010 |
| | | | | KR | 20120030337 | A | 28 March 2012 |
| | | | | US | 9214822 | B2 | 15 December 2015 |
| | | | | CN | 102460893 | A | 16 May 2012 |
| | | | | CN | 102460893 | B | 05 November 2014 |
| CN | 106394313 | A | 15 February 2017 | CN | 106394313 | B | 26 March 2019 |
| CN | 112462917 | A | 09 March 2021 | None | | | |
| CN | 112865264 | A | 28 May 2021 | None | | | |
| JP | 2017158264 | A | 07 September 2017 | JP | 6678342 | B2 | 08 April 2020 |
| US | 2017182893 | A1 | 29 June 2017 | JP | 2015154529 | A | 24 August 2015 |
| | | | | JP | 6112033 | B2 | 12 April 2017 |
| | | | | KR | 20160119167 | A | 12 October 2016 |
| | | | | KR | 101873666 | B1 | 02 July 2018 |
| | | | | EP | 3107178 | A1 | 21 December 2016 |
| | | | | EP | 3107178 | A4 | 10 May 2017 |
| | | | | EP | 3107178 | B1 | 05 December 2018 |
| | | | | US | 10259328 | B2 | 16 April 2019 |
| | | | | WO | 2015122214 | A1 | 20 August 2015 |
| | | | | CN | 105981255 | A | 28 September 2016 |
| | | | | CN | 105981255 | B | 21 December 2018 |

Form PCT/ISA/210 (patent family annex) (July 2022)